(19) Europäisches Patentamt
European Patent Office
Office européen des brevets

(11) **EP 4 040 479 A1**

(12) **EUROPEAN PATENT APPLICATION**
published in accordance with Art. 153(4) EPC

(43) Date of publication:
**10.08.2022 Bulletin 2022/32**

(21) Application number: 20873116.6

(22) Date of filing: **29.09.2020**

(51) International Patent Classification (IPC):
**H01L 23/36** (2006.01)      **H01L 23/373** (2006.01)
**C08L 5/00** (2006.01)        **C08L 21/00** (2006.01)
**C08J 5/18** (2006.01)        **C08K 3/01** (2018.01)

(52) Cooperative Patent Classification (CPC):
**C08J 5/18; C08K 3/01; C08L 5/00; C08L 21/00;
H01L 23/36; H01L 23/373**

(86) International application number:
**PCT/JP2020/036869**

(87) International publication number:
**WO 2021/065899 (08.04.2021 Gazette 2021/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.09.2019  JP 2019180340
30.09.2019  JP 2019180344**

(71) Applicant: **SEKISUI CHEMICAL CO., LTD.**
**Osaka-shi**
**Osaka**
**530-8565 (JP)**

(72) Inventors:
• **TSUCHIYA, Kento**
**Hasuda-shi, Saitama 349-0198 (JP)**
• **HOSHIYAMA, Yuuki**
**Hasuda-shi, Saitama 349-0198 (JP)**

(74) Representative: **Ter Meer Steinmeister & Partner**
**Patentanwälte mbB**
**Nymphenburger Straße 4**
**80335 München (DE)**

(54) **THERMALLY CONDUCTIVE RESIN SHEET**

(57)      A heat-conductive resin sheet of the present invention has a thermal conductivity of 5 W/m·K or more, a 30% compressive strength of 2000 kPa or less, a content of a compound having an ester bond of 1000 ppm or less, and a rate of change of the 30% compressive strength of 30% or less after a heat resistance test. According to the present invention, there can be provided a heat-conductive resin sheet that has excellent thermal conductive property, flexibility, and long-term stability of physical property such as not becoming hardened over time and can reduce a clouding in a lens or the like provided in an electronic device.

Fig 1

EP 4 040 479 A1

**Description**

Technical Field

The present invention relates to a heat-conductive resin sheet.

Background Art

A heat-conductive resin sheet is primarily disposed between a heating element such as a semiconductor package and a heat sink such as aluminum or copper and has a function to quickly move the heat generated at the heating element to the heat sink. In recent years, higher integration of semiconductor elements and high-density wiring on a semiconductor package have been increasing an amount of heat generation per unit area of a semiconductor package and, as a result, a demand has been increasing for heat-conductive resin sheets with a more improved thermal conductivity and a capability of facilitating quicker heat dissipation when compared with the conventional heat-conductive resin sheets.

A heat-conductive resin sheet comprising a heat-conductive filler is known as such a heat-conductive resin sheet. For example, PTL1 describes an invention regarding a heat-conductive resin sheet comprising a liquid polybutene and a heat-conductive filler, and PTL2 describes an invention regarding a heat-conductive resin sheet comprising an epoxy resin and hexagonal boron nitride as a heat-conductive filler.

Citation List

Patent Literature

PTL1: JP 2012-38763 A
PTL2: JP 2013-254880 A

Summary of Invention

Technical Problem

There is a concern that when a heat-conductive resin sheet in general has an increased content of a heat-conductive filler to improve a thermal conductivity, the sheet hardens and causes solder cracks, warping of a substrate and the like in an electronic device in which the sheet is used, thus damaging the electronic components. That is, it is difficult to increase a thermal conductivity of a heat-conductive resin sheet while maintaining satisfactory flexibility, and hence techniques that make them compatible are in demand.

In addition to this, in recent years, attention has been paid as a problem to a long-term use of a heat-conductive resin sheet which causes changes of physical properties over time such as making it hard and damaging electronic components, and accordingly the maintenance of long-term stability of physical properties is demanded. Further, a heat-conductive resin sheet is often used in an electronic device and the like having a camera lens, and attention has been paid as a problem to clouding of the lens due to an outgas generated from the sheet and malfunctions caused thereby. For this reason, a heat-conductive resin sheet that generates a reduced amount of an outgas is demanded.

The present invention is made in view of the above conventional problems, and it is an object thereof to provide a heat-conductive resin sheet that has excellent thermal conductive property, flexibility, and long-term stability of physical property such as not becoming hardened over time and even when used in an electronic device or the like having a camera lens, can reduce a clouding of the lens.

Solution to Problem

The present inventors have made intensive studies to achieve the goals. The present inventors consequently have found that the above object is solved by a heat-conductive resin sheet having a thermal conductivity of 5 W/m·K or more, a 30% compressive strength of 2000 kPa or less, a content of a compound having an ester bond of 1000 ppm or less, and a rate of change of the 30% compressive strength of 30% or less after a heat resistance test, whereby the present invention was accomplished. Further, the present inventors have found that the above object is solved also by a heat-conductive resin sheet having a thermal conductivity of 5 W/m·K or more, a 30% compressive strength of 2000 kPa or less, a gloss retention in a fogging test of 70% or more, and a rate of change of the 30% compressive strength of 30% or less after a heat resistance test, whereby the present invention was accomplished.

That is, the present invention relates to the following [1] to [11].

[1] A heat-conductive resin sheet having a thermal conductivity of 5 W/m·K or more, a 30% compressive strength of 2000 kPa or less, a content of a compound having an ester bond of 1000 ppm or less, and a rate of change of the 30% compressive strength of 30% or less after a heat resistance test.

[2] A heat-conductive resin sheet having a thermal conductivity of 5 W/m·K or more, a 30% compressive strength of 2000 kPa or less, a gloss retention in a fogging test of 70% or more, and a rate of change of the 30% compressive strength of 30% or less after a heat resistance test.

[3] The heat-conductive resin sheet according to the above [1], wherein the gloss retention in a fogging test is 70% or more.

[4] The heat-conductive resin sheet according to any of the above [1] to [3], comprising an antioxidant.

[5] The heat-conductive resin sheet according to the above [4], wherein the antioxidant is an antioxidant having no ester bond.

[6] The heat-conductive resin sheet according to the above [5], wherein the antioxidant is an antioxidant having no tertiary carbon nor quaternary carbon.

[7] The heat-conductive resin sheet according to any of the above [1] to [6], comprising an elastomer resin.

[8] The heat-conductive resin sheet according to the above [7], wherein the elastomer resin comprises a liquid elastomer resin.

[9] The heat-conductive resin sheet according to any of the above [1] to [8], comprising a heat-conductive filler.

[10] The heat-conductive resin sheet according to the above [9], wherein the heat-conductive filler comprises a non-spherical filler.

[11] The heat-conductive resin sheet according to any of the above [1] to [10], which is crosslinked.

Advantageous Effects of Invention

According to the present invention, there can be provided a heat-conductive resin sheet that has excellent thermal conductive property, flexibility, and long-term stability of physical property such as not becoming hardened over time and can reduce a clouding of a lens provided in an electronic device or the like.

Brief Description of Drawings

[Fig. 1] Fig. 1 is a schematic cross-sectional view of a heat-conductive resin sheet consisting of a laminated body.
[Fig. 2] Fig. 2 is a schematic cross-sectional view of a heat-conductive resin sheet consisting of a laminated body in operation.

Description of Embodiments

[Heat-conductive resin sheet]

The heat-conductive resin sheet of the present invention has a thermal conductivity of 5 W/m·K or more, and a 30% compressive strength of 2000 kPa or less. In general, a heat-conductive resin sheet tends to reduce flexibility as a thermal conductivity increases but the heat-conductive resin sheet of the present invention has a 30% compressive strength of 2000 kPa or less and good flexibility as well despite a high thermal conductivity of 5 W/m·K or higher.

Additionally, the heat-conductive resin sheet of the present invention has a rate of change of the 30% compressive strength of 30% or less after a heat resistance test, thereby having good long-term stability of physical properties.

Further, the heat-conductive resin sheet of the present invention has a content of a compound having an ester bond of 1000 ppm or less or a gloss retention in a fogging test of 70% or more. This can reduce outgas generation and reduce a clouding of the lens of an electronic device or the like. The heat-conductive resin sheet of the present invention preferably has a content of a compound having an ester bond of 1000 ppm or less and a gloss retention in a fogging test of 70% or more, from a viewpoint of further reducing the outgas generation.

(Thermal conductivity)

A thermal conductivity of the heat-conductive resin sheet of the present invention is 5 W/m·K or more. A thermal conductivity of less than 5 W/m·K fails to sufficiently dissipate the heat generated from a heating element. A thermal conductivity of the heat-conductive resin sheet is, from a viewpoint of improving the heat dissipation property of the heat-conductive resin sheet, preferably 7 W/m·K or more, and more preferably 10 W/m·K or more. Additionally, the higher a thermal conductivity of the heat-conductive resin sheet, the better, but is typically 100 W/m·K or less. A thermal conductivity is more likely to be adjusted to the desired value by, for example, adjusting the content and the orientation of heat-conductive fillers to be described later.

(30% Compressive strength)

The 30% compressive strength of heat-conductive resin sheet of the present invention is 2000 kPa or less. A 30% compressive strength of more than 2000 kPa reduces the flexibility of the sheet and is more likely to damage electronic components in an electronic device in which such a sheet is used. A 30% compressive strength of the heat-conductive resin sheet is, from a viewpoint of increasing the flexibility of the heat-conductive resin sheet, preferably 1500 kPa or less, more preferably 1000 kPa or less, and further preferably 800 kPa or less. Additionally, a 30% compressive strength of the heat-conductive resin sheet is typically 50 kPa or more, and preferably 200 kPa or more.

The 30% compressive strength of the heat-conductive resin sheet can be adjusted by the kind of resin composing the heat-conductive resin sheet, the presence or absence of crosslinking, the amount of heat-conductive fillers and the like to be described later.

The 30% compressive strength means the load obtained when the resin sheet is compressed by a thickness equivalent to 30% of the original thickness and can be determined by the method described in an example.

The heat-conductive resin sheet of the present invention has a rate of change of the 30% compressive strength of 30% or less after a heat resistance test. A rate of change of the 30% compressive strength after a heat resistance test of more than 30% hardens the heat-conductive resin sheet after a long-term use and is thereby likely to damage electronic components in an electronic device in which such a sheet is used. A rate of change of the 30% compressive strength after a heat resistance test of the heat-conductive resin sheet is, from a viewpoint of maintaining a suitable flexibility of the heat-conductive resin sheet and long-term stable use, preferably 0 to 20%, more preferably 0 to 15%, and further preferably 0 to 10%.

The rate of change of the 30% compressive strength after a heat resistance test can be adjusted by the presence or absence of an antioxidant to be used, the kind of resin, the amount of heat-conductive fillers, the gel fraction and the like to be described later to be used.

In the present description, the heat resistance test means the test in which a sample (heat-conductive resin sheet) is heated for 1000 hours at 150°C. Additionally, the rate of change (%) of the 30% compressive strength after the heat resistance test can be determined by the following formula (1).

$$|(1 - \text{30\% Compressive strength before heat resistance test} / \text{30\% compressive strength after heat resistance test}) \times 100| \quad \text{Formula (1)}$$

Formula (1) indicates the absolute value of (1 - 30% compressive strength before heat resistance test / 30% compressive strength after heat resistance test) × 100.

(Content of compound having ester bond)

The content (weight) of a compound having an ester bond in the heat-conductive resin sheet of the present invention is 1000 ppm or less. This can reduce outgas generation and prevent clouding of a camera lens provided in an electronic device. It is assumed that the compound having an ester bond is easily decomposed due to heating on production of the heat-conductive resin sheet or when the heat-conductive resin sheet is crosslinked with an organic peroxide or an ionizing radiation and that the decomposed product causes a camera lens to be clouded.

The content of the compound having an ester bond in the heat-conductive resin sheet is preferably 500 ppm or less, more preferably 100 ppm or less, and further preferably 0 ppm.

Examples of the compound having an ester bond include a resin having an ester bond and various additives having an ester bond.

Examples of the resin having an ester bond include acryl-based resins, and polyester-based resins such as polyethylene terephthalate and polybutylene terephthalate.

Examples of various additives having an ester bond include an antioxidant, a heat stabilizer, a coloring agent, a fire retardant, and an antistatic agent having an ester bond.

(Gloss retention)

The gloss retention in a fogging test of the heat-conductive resin sheet of the present invention is preferably 70% or more. A gloss retention of 70% or more reduces a clouding in a lens or the like provided in an electronic device or the like, and malfunctions are more unlikely to occur. The gloss retention in a fogging test of the heat-conductive resin sheet is preferably 75% or more and more preferably 80% or more. The upper limit of the gloss retention is 100%.

The fogging test is conducted in accordance with German industrial standard DIN75201-A. Specifically, a disk-shaped heat-conductive resin sheet having a thickness of 2 mm and a diameter of 80 mm is placed in a beaker having a height of 1000 mL, a glass plate is put on the top of the beaker so as to cover the beaker, and a cooling plate maintained at a temperature of 21°C is further put on the glass plate. Subsequently, the beaker including the heat-conductive resin sheet is heated to 100°C in an oil bath. Then, after the beaker is maintained in this state for 16 hours, the glossiness of the surface of the glass plate is measured. From the gloss value of the glass plate after the test thus obtained (gloss value after test) and the gloss value of the glass plate before the test (gloss value before test), the gloss retention can be determined by the following formula.

$$\text{Gloss retention (\%)} = 100 \times \text{(gloss value after test)} / \text{(gloss value before test)}$$

The above gloss value is the gloss value at 60°, which is a value measured with a gloss meter (manufactured by Murakami Color Research Laboratory, "Precision Gloss Meter GM-26PRO").

The gloss retention can be adjusted by the above-described content of a compound having an ester bond, the type of antioxidant, mixing amounts of resin and heat-conductive fillers.

(Resin)

The heat-conductive resin sheet of the present invention comprises a resin, and the kind of the resin is not particularly limited but, from a viewpoint of imparting satisfactory flexibility, an elastomer resin is preferable.

Examples of the kind of elastomer resin include acrylonitrile butadiene rubbers, ethylene-propylene-diene rubbers, ethylene-propylene rubbers, natural rubbers, polyisoprene rubbers, polybutadiene rubbers, hydrogenated polybutadiene rubbers, styrene-butadiene block copolymers, hydrogenated styrene-butadiene block copolymers, hydrogenated styrene-butadiene-styrene block copolymers, hydrogenated styrene-isoprene block copolymers, and hydrogenated styrene-isoprene-styrene block copolymers.

The above elastomer resins may be solid elastomers or may be liquid elastomers, at room temperature (23°C) and atmospheric pressure (1 atm).

A content of the elastomer resin is, on a basis of the resin total amount in the heat-conductive resin sheet of the present invention, preferably 60 mass% or more, more preferably 80 mass% or more, and further preferably 100 mass%.

The elastomer resin in the heat-conductive resin sheet preferably comprises a liquid elastomer resin from a viewpoint of improving the flexibility of the heat-conductive resin sheet of the present invention. The liquid elastomer resin is not particularly limited and, for example, liquid elastomer resins from the above elastomer resins can be used, with liquid acrylonitrile butadiene rubbers, liquid ethylene-propylene-diene rubbers, liquid polyisoprene rubbers, and liquid polybutadiene rubbers being preferable.

The elastomer resin may be used singly, or a plurality of kinds may be used in combination.

A viscosity of the liquid elastomer resin at 25°C is preferably 1 to 150 Pa·s, and more preferably 10 to 100 Pa·s. When 2 or more kinds of liquid elastomer resins are used in mixture, the viscosity after mixed is preferably as described above. When a viscosity is within the above range, stains on electronic components are more likely to be prevented.

A content of the liquid elastomer to a basis of the total amount of elastomer resin is preferably 60 mass% or more, more preferably 90 mass% or more, and further preferably 100 mass%.

(Heat-conductive filler)

The heat-conductive resin sheet of the present invention preferably comprises heat-conductive fillers. The heat-conductive fillers are preferably dispersed in the resin in the heat-conductive resin sheet. The thermal conductivity of the heat-conductive filler is not particularly limited and is preferably 12 W/m·K or more, more preferably 12 to 300 W/m·K, further preferably 15 to 70 W/m·K, and further preferably 25 to 70 W/m·K.

Examples of the material for heat-conductive filler include carbides, nitrides, oxides, hydroxides, metals, and carbon-based materials.

Examples of the carbide include silicon carbides, boron carbides, aluminum carbides, titanium carbides, and tungsten carbides.

Examples of the nitride include silicon nitrides, boron nitrides, boron nitride nanotubes, aluminum nitrides, gallium nitrides, chromium nitrides, tungsten nitrides, magnesium nitrides, molybdenum nitrides, and lithium nitrides.

Examples of the oxide include iron oxides, silicon oxides (silica), aluminum oxides (alumina) (including hydrates of aluminum oxide (boehmite and the like)), magnesium oxides, titanium oxides, cerium oxides, and zirconium oxides. Additional examples of the oxide include transition metal oxides such as barium titanate and further doped metal ions such as indium tin oxide and antimony tin oxide.

Examples of the hydroxide include aluminum hydroxides, calcium hydroxides, and magnesium hydroxides.

Examples of the metal include copper, gold, nickel, tin, iron, and alloys thereof.

Examples of the carbon-based material include carbon black, graphite, diamond, graphene, fullerene, carbon nanotube, carbon nanofiber, nanohorn, carbon micro coil, and nanocoil.

Examples of the heat-conductive filler other than the above include talc, which is a silicate mineral.

These heat-conductive fillers can be used singly or 2 or more kinds can be used in combination. The heat-conductive filler is, from a viewpoint of thermal conductive property, preferably at least 1 kind selected from the group consisting of aluminum oxides, magnesium oxides, boron nitrides, aluminum nitrides, graphene, boron nitride nanotubes, carbon nanotube and diamond. Additionally, the heat-conductive filler, when being the non- spherical filler to be described later, is preferably at least either boron nitrides or graphene, whereas aluminum oxides are preferable in the case of a spherical filler. For the purpose of use that further requires electrical insulation property, boron nitrides are more preferable.

An average particle size of the heat-conductive fillers is preferably 0.1 to 300 $\mu$m, more preferably 0.5 to 100 $\mu$m, and further preferably 5 to 50 $\mu$m. The average particle size can be determined by measuring a particle size distribution using a laser diffraction particle size distribution analyzer.

A content of the heat-conductive fillers in the heat-conductive resin sheet to 100 parts by mass of the resin is preferably 180 to 3000 parts by mass, more preferably 200 to 2500 parts by mass, and further preferably 250 to 1000 parts by mass.

It is preferable that the content of the heat-conductive fillers be adjusted in accordance with the shape of the filler.

The shape of a heat-conductive filler is not particularly limited and may be a spherical filler or a non-spherical filler, but a non-spherical filler is preferable.

It is preferable for the heat-conductive filler to comprise a non-spherical filler. When a non-spherical filler is used, a thermal conductive property is easily improved with a comparatively smaller amount, thereby likely obtaining the heat-conductive resin sheet in which satisfactory flexibility and high thermal conductive property are compatible.

The "spherical" herein means the shape having an aspect ratio of 1.0 to 2.0, and preferably 1.0 to 1.5, and does not necessarily mean perfectly spherical. The aspect ratio for a spherical filler means the ratio of the longest diameter/the shortest diameter. Additionally, the "non-spherical" means the shapes other than the above spherical shape, that is, the shapes having aspect ratios more than 2.

Examples of the non-spherical filler include plate-like fillers such as scale-like fillers and flake fillers, needle-like fillers, fibrous fillers, dendrite fillers, and irregular-shape fillers. Of these, plate-like fillers are preferable from a viewpoint of imparting satisfactory thermal conductive property to the heat-conductive resin sheet.

The aspect ratio of a heat-conductive filler is, from a viewpoint of improving the thermal conductive property, preferably 5 or more, more preferably 10 or more, and further preferably 15 or more.

The heat-conductive resin sheet can have further improved thermal conductive property in the thickness direction when heat-conductive fillers having a high aspect ratio are oriented at a high orientation angle as to be described later.

The aspect ratio of a non-spherical filler is the ratio of the maximum length to the minimum length (maximum length/minimum length) of the filler, and, when the shape is plate-like, for example, the aspect ratio is the ratio of the maximum length to the thickness of the filler (maximum length/ thickness). The aspect ratio can be determined in terms of an average value by observing adequate number (for example, 250 pieces) of heat-conductive fillers using a scanning electron microscope.

The minimum length (equivalent to the thickness in the case of a plate-like filler) of a heat-conductive filler is, from a viewpoint of improving the thermal conductivity, preferably 0.05 to 500 $\mu$m, and more preferably 0.25 to 250 $\mu$m.

When the heat-conductive filler comprises non-spherical fillers, a content of the non-spherical fillers is, to 100 parts by mass of the resin, preferably 180 to 700 parts by mass, more preferably 200 to 600 parts by mass, and further preferably 300 to 500 parts by mass. A content of 180 parts by mass or more increases thermal conductive property, thus more likely achieving the thermal conductivity specified in the present invention. Additionally, a content of 700 parts by mass or less is likely to provide satisfactory flexibility.

A content of non-spherical fillers in the heat-conductive filler on a basis of the total amount of the heat-conductive fillers is preferably 60 mass% or more, more preferably 90 mass% or more, and further preferably 100 mass%.

(Antioxidant)

The heat-conductive resin sheet of the present invention preferably comprises an antioxidant. When the heat-conductive resin sheet comprises an antioxidant, the rate of change of the 30% compressive strength of the heat-conductive resin sheet after a heat resistance test is reduced, and the long-term stability of physical properties is improved.

Examples of the antioxidant include, but are not particularly limited to, phenol-based antioxidants, amine-based antioxidants, and sulfur-based antioxidants.

A phenol-based antioxidant here is a compound having a phenolic hydroxyl group. An amine-based antioxidant is a compound having an amino group. A sulfur-based antioxidant is a compound having a sulfur atom. When an antioxidant having two groups of these, the antioxidant corresponds to two types of the antioxidants. For example, a compound having a phenolic hydroxyl group and an amino group corresponds to both a phenol-based antioxidant and an amine-based antioxidant.

As the antioxidant, an antioxidant having no ester bond is preferred. When an antioxidant having no ester bond is used, the gloss retention of the fogging test increases, clouding of a lens provided in an electronic device or the like is prevented, and malfunctions are more unlikely to occur.

Examples of the antioxidant having no ester bond include phenol-based antioxidants such as 1,3,5-tris(3,5-di-tert-butyl-4-hydroxybenzyl)-1,3,5-triazine-2,4,6-(1H,3H,5H)-trione, 4,4',4'-(1-methylpropanyl-3-ylidene)tris(6-tert-butyl-m-cresol), 6,6'-di-tert-butyl-4,4'-butylidene-di-m-cresol, and 1,3,5-tris(3,5-di-tert-butyl-4-hydroxyphenylmethyl)-2,4,6-trimethylbenzene; sulfur-based antioxidants such as 2-mercaptobenzothiazole, 2-mercaptobenzimidazole, and tetramethylthiuram monosulfide; and amine-based antioxidants such as phenyl naphthylamine, 4,4'-dimethoxydiphenylamine, 4,4'-bis($\alpha,\alpha$-dimethylbenzyl)diphenylamine, 4-isopropoxydiphenylamine, 3-(N-salicyloyl)amino-1,2,4 triazole, and N,N'-di-2-naphthyl-p-phenylenediamine.

Preferred among these are 1,3,5-tris(3,5-di-tert-butyl-4-hydroxyphenylmethyl)-2,4,6-trimethylbenzene, 3-(N-salicyloyl)amino-1,2,4 triazole, and N,N'-di-2-naphthyl-p-phenylenediamine.

As the antioxidant, an antioxidant having no ester bond and having no tertiary carbon nor quaternary carbon is preferred. When such an antioxidant is used, a clouding in a camera lens provided in an electronic device or the like is more effectively reduced, and additionally long-term stability of physical properties is improved. Here, tertiary carbon is carbon bonded to 3 carbon atoms, and quaternary carbon is carbon bonded to 4 carbon atoms. Carbon atoms constituting an aromatic ring such as a benzene ring, a naphthalene ring, or the like do not correspond to either tertiary carbon or quaternary carbon.

Examples of a preferred antioxidant include phenol-based antioxidants or amine-based antioxidants having no ester bond and having no tertiary carbon nor quaternary carbon.

Particularly preferred antioxidants among antioxidants having no ester bond and having no tertiary carbon nor quaternary carbon are 3-(N-salicyloyl)amino-1,2,4 triazole and N,N'-di-2-naphthyl-p-phenylenediamine.

A content of the antioxidant in the heat-conductive resin sheet to 100 parts by mass of the resin is preferably 0.1 to 20 parts by mass, more preferably 0.5 to 10 parts by mass, and further preferably 1 to 5 parts by mass. When the content of the antioxidant is equal to or more than these lower limits, the rate of change of the 30% compressive strength after a heat resistance test is reduced, and the long-term stability of physical properties is improved. When the content of the antioxidant is equal to or less than these upper limits, clouding of a camera lens provided in an electronic device or the like is more likely to be prevented.

(Other additives)

Additives other than the antioxidant may be added as needed to the heat-conductive resin sheet of the present invention. As such other additives, additives generally used in heat-conductive resin sheets such as a heat stabilizer, a coloring agent, a fire retardant, an antistatic agent, a filler other than the heat-conductive fillers, and a decomposition temperature regulator may be mixed.

(Orientation)

In the heat-conductive resin sheet, the major axis of a heat-conductive filler is preferably oriented at an angle more than 45° to the sheet surface, which is the surface of the heat-conductive resin sheet, and more preferably oriented at an angle of 50° or more, further preferably 60° or more, further preferably 70° or more, and further preferably 80° or more. The heat-conductive fillers, when oriented as such, improve the thermal conductivity in the thickness direction of the heat-conductive resin sheet. The major axis of a heat-conductive filler has the same direction as the maximum length of the heat-conductive filler described above.

The above angle can be measured by observing the cross-section of the thickness direction of the heat-conductive resin sheet using a scanning electron microscope. For example, a thin slice of the center portion in the thickness direction of the heat-conductive resin sheet is first prepared. Subsequently, the heat-conductive fillers in the thin slice are observed using a scanning electron microscope (SEM) at 3000x magnification, and angles formed between the major axis of the observed fillers and the plane composing the sheet surface are measured and thereby determined. In the present description, the angles of 45° or more, 50° or more, 60° or more, 70° or more, and 80° or more mean an average value of the values measured as described above is these angles or more. For example, in the "oriented at an angle of 70° or more", the 70° is an average value, and the presence of heat-conductive fillers having orientation angles of less than 70° is not denied. When a formed angle is more than 90°, a supplementary angle thereof is used as the measured value.

(Gel fraction)

The heat-conductive resin sheet of the present invention is preferably crosslinked and preferably has a certain gel fraction (crosslinking degree) from a viewpoint of making the long-term stability of physical properties good.

A gel fraction throughout the heat-conductive resin sheet is, from a viewpoint of imparting satisfactory flexibility, preferably 50 mass% or less, and more preferably 40 mass% or less, and is also preferably 5 mass% or more, and preferably 10 mass% or more, from a viewpoint of reducing the rate of change of the 30% compressive strength after the heat resistance test.

(Laminated body)

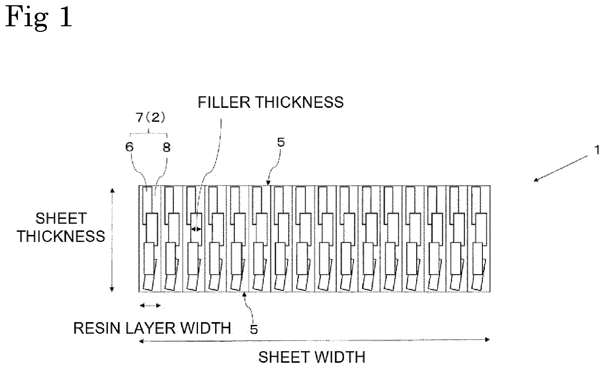

The heat-conductive resin sheet of the present invention may be a single layer or a laminated body. A laminated body in which resin layers comprising a resin and non-spherical fillers are laminated is preferable from a viewpoint of imparting satisfactory thermal conductive property. Hereinbelow, an embodiment example of the laminated body in which resin layers comprising a resin and non-spherical fillers are laminated is described in reference to Fig. 1.

In each figure, each of the fillers lies on top of and beneath adjacent fillers, but the fillers do not necessarily have to overlap with each other.

As shown in Fig. 1, a heat-conductive resin sheet 1 has a structure in which a plurality of resin layers 2 are laminated. A vertical plane to the lamination plane of a plurality of resin layers 2 is a sheet surface 5, which is the surface of the resin sheet 1.

The thickness of the heat-conductive resin sheet 1 (that is, the distance between the sheet surface 5 and the sheet surface 5) is not particularly limited and can be, for example, ranged from 0.1 to 30 mm.

The thickness of a single layer of the resin layers 2 (resin layer width) is not particularly limited and is preferably 1000 $\mu$m or less, and more preferably 500 $\mu$m or less, and preferably 0.1 $\mu$m or more, more preferably 0.5 $\mu$m or more, and further preferably 1 $\mu$m or more. The adjustment of thickness as such can enhance the thermal conductive property.

The resin layer 2 is a heat-conductive resin layer 7 comprising heat-conductive fillers 6. The heat-conductive resin layer 7 has a structure in which heat-conductive fillers 6 having thermal conductive property are dispersed in a resin 8.

In each of the resin layers 2, the heat-conductive fillers are oriented at an angle more than 45° to the sheet surface as described above, and more preferably at an angle of 50° or more, further preferably 60° or more, further preferably 70° or more, and further preferably 80° or more.

A thickness of the heat-conductive resin layer 7 is preferably 1 to 1000 times, and more preferably 1 to 500 times, the thickness of the heat-conductive filler 6 comprised in the heat-conductive resin layer 7.

When a width (thickness) of the heat-conductive resin layer 7 is in the above range, the major axis of the heat-conductive filler 6 is more likely to be oriented at an angle close to 90° to the sheet surface. The width of the heat-conductive resin layer 7 does not have to be uniform as long as it is within the above range.

[Method for producing a heat-conductive resin sheet]

The method for producing the heat-conductive resin sheet of the present invention is not particularly limited, and in the case of producing a single-layer heat-conductive resin sheet, for example, non-spherical heat-conductive fillers, a resin, and additives as needed are fed to an extruder, melt-kneaded to obtain a mixture, and the mixture is extruded into a sheet from the extruder, whereby a heat-conductive resin sheet is formed.

(Method for producing a laminated body)

The method for producing the heat-conductive resin sheet consisting of a laminated body of the present invention is not particularly limited, and as describe below, such a resin sheet can be produced by a method comprising a kneading step, a lamination step, and further a slicing step as needed.

<Kneading step>

Heat-conductive fillers and a resin are kneaded to manufacture a heat-conductive resin composition.
The kneading is preferably carried out by, for example, kneading heat-conductive fillers and a resin using a twin-screw kneader such as a plastomill or a biaxial extruder with heating, and this enables to obtain the heat-conductive resin composition in which the heat-conductive fillers are uniformly dispersed in the resin.
Subsequently, the heat-conductive resin composition is pressed thereby to obtain a sheet-like resin layer (heat-conductive resin layer).

<Lamination step>

In the lamination step, the resin layers obtained in the kneading step are laminated to manufacture a laminated body having an n-layer structure. A method usable as the lamination method is, for example, a method in which the resin layer manufactured in the kneading step is divided into $x_i$ and laminated to manufacture a laminated body having an $x_i$-layer structure, then hot-pressed as needed, subsequently the division, the lamination and the hot-pressing are further repeated as needed to manufacture a laminated body having a width of D $\mu$m and an n-layer structure.
When the heat-conductive filler is plate-like, a width of the laminating body (D $\mu$m) after the lamination step and a thickness of the heat-conductive filler (d $\mu$m) preferably satisfy $0.0005 \leq d/(D/n) \leq 1$, more preferably satisfy $0.001 \leq d/(D/n) \leq 1$, and further preferably satisfy $0.02 \leq d/(D/n) \leq 1$.
Thus, when a plurality of formations are carried out, a forming pressure at each formation can be smaller than the case of a one-time formation, whereby phenomena such as rupture of the laminate structure caused by the formation can be eliminated.
Other lamination methods also usable include, for example, a method in which an extruder equipped with a multilayer forming block is used, and the multilayer forming block is adjusted to obtain a laminated body having the n-layer structure and the width of D $\mu$m by co-extrusion.
Specifically, the heat-conductive resin composition obtained in the kneading step is introduced into both of a first extruder and a second extruder, and the heat-conductive resin compositions are extruded simultaneously from the first extruder and the second extruder. The heat-conductive resin compositions extruded from the first extruder and the second extruder are delivered to a feed block. In the feed block, the heat-conductive resin compositions extruded from the first extruder and the second extruder are merged. As a result, a 2-layer body in which the heat-conductive resin compositions are laminated can be obtained. Subsequently, the 2-layer body is transferred to a multilayer forming block, and the 2-layer body is divided into a plurality of pieces in the direction parallel to the extrusion direction and along with a plurality of planes vertical to the lamination plane and then laminated, whereby a laminated body having an n-layer structure and a width of D $\mu$m can be manufactured. During this process, the thickness per layer (D/n) can be a desired value by adjusting the multilayer forming block.

(Slicing step)

The laminated body obtained in the lamination step is sliced in the direction parallel to the lamination direction thereby to manufacture the heat-conductive resin sheet.

(Other steps)

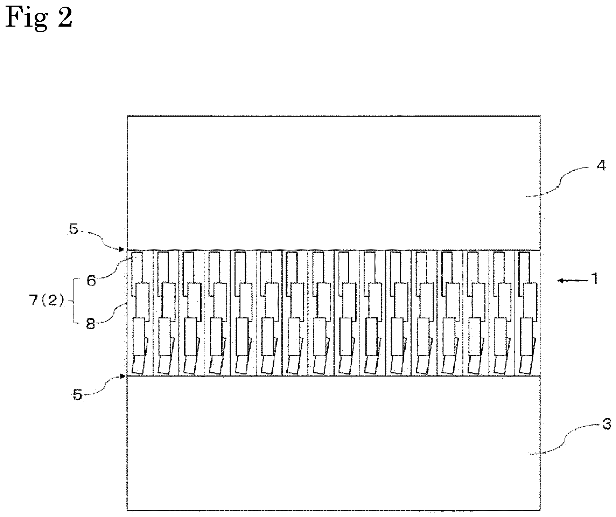

In the method for producing the heat-conductive resin sheet, a step of crosslinking the resin is preferably provided. Crosslinking is more likely to reduce a rate of change of the 30% compressive strength after the heat resistance test of the heat-conductive resin sheet. Crosslinking can be carried out by, for example, a method of irradiating an ionizing radiation such as electron beam, $\alpha$ ray, $\beta$ ray, or $\gamma$ ray, or a method that uses an organic peroxide. From a viewpoint of reducing the rate of change of the 30% compressive strength, when the electron beam irradiation is carried out, an accelerating voltage is preferably 50 to 800 kV, more preferably 200 to 700 kV, and further preferably 400 to 600 kV. From the same viewpoint, an irradiation dose of the electron beam irradiation is preferably 200 to 1200 kGy, more preferably 300 to 1000 kGy, and further preferably 400 to 800 KGy.
The heat-conductive resin sheet of the present invention has good thermal conductive property and flexibility, a low rate of change of the 30% compressive strength after the heat resistance test, and good long-term stability of physical properties. With utilizing these characteristics, the heat-conductive resin sheet of the present invention, for example, when disposed between heating elements and a heat sink in an electronic device, can facilitate the heat dissipation from the heating elements to the heat sink. This is described in reference to the heat-conductive resin sheet 1 illustrated in Fig. 1.
As shown in Fig. 2, in the heat-conductive resin sheet 1, a sheet surface 5 is disposed in such a way as to contact a heating element 3 and a heat sink 4. Further, the heat-conductive resin sheet 1 is disposed between 2 members such as the heating element 3 and the heat sink 4 in a compressed state. The heating element 3 is, for example, a semiconductor package, and the heat sink 4 is, for example, metals such as aluminum and copper. When the heat-conductive resin sheet 1 is used in such a state, the heat generated in the heating element 3 is more likely to be diffused to the heat sink 4 thereby enabling efficient heat radiation.

Further, the heat-conductive resin sheet of the present invention has a certain value or less of the amount of the compound having an ester bond, and thus a clouding of a camera lens provided in an electronic device or the like can be reduced. For this reason, the heat-conductive resin sheet is particularly preferably used in an electronic device having a camera lens, such as an onboard camera, a drive recorder, a digital camera, a smartphone, and a mobile phone. This can reduce a clouding of the camera lens and prevent malfunctions of the electronic device.

Examples

The present invention is described in further detail in reference to examples but is not limited at all to these examples.

Materials used in the following examples and comparative examples are as follows.

(1) Resin

- Liquid elastomer 1: liquid polybutadiene rubber, manufactured by KURARAY CO., LTD., product name "L-1203", viscosity at 25°C: 35 Pa·s

(2) Heat-conductive filler

(i) Boron nitride, manufactured by Denka Company Limited., product name "SGP"

Shape: non-spherical (plate-like)
Aspect ratio: 20
Long-side direction thermal conductivity: 250 W/m·K
Thickness: 1 $\mu$m

(3) Antioxidant

(i) Antioxidant 1 (having an ester group and having quaternary carbon)
Pentaerythritol tetrakis[3-(3,5-di-tert-butyl-4-hydroxyphenyl)propionate], manufactured by ADEKA Corporation, product name "ADK STAB AO-60"
(ii) Antioxidant 2 (no ester group and no tertiary carbon nor quaternary carbon)
3-(N-Salicyloyl)amino-1,2,4 triazole, manufactured by ADEKA Corporation, product name "ADK STAB CDA-1"
(iii) Antioxidant 3 (having ester and no tertiary carbon nor quaternary carbon)
Distearyl thiodipropionate, manufactured by Ouchi Shinko Chemical Industrial Co., Ltd. "NOCRAC 400S"
(iv) Antioxidant 4 (no ester group and having quaternary carbon)
1,3,5-Tris(3,5-di-tert-butyl-4-hydroxyphenylmethyl)-2,4,6-trimethylbenzene, manufactured by ADEKA Corporation, product name "ADK STAB AO-330"
(v) Antioxidant 5 (no ester group and no tertiary carbon nor quaternary carbon)
N,N'-Di-2-naphthyl-p-phenylenediamine, manufactured by Ouchi Shinko Chemical Industrial Co., Ltd. "NOCRAC White"

Physical properties and evaluation methods are as follows.

<Viscosity>

Fifty g of a resin was measured at 25°C using a B-type viscometer (manufactured by TOYO-SANGYO. Co. Ltd.).

<Thermal conductivity>

A thermal conductivity in the thickness direction of the obtained heat-conductive resin sheet was measured using a Laser Flash Thermal Conductivity Analyzer (manufactured by NETZSCH, "LFA447").

<30% Compressive strength>

A 30% compressive strength of the obtained heat-conductive resin sheet was measured using "RTG-1250" manufactured by A&D Company, Limited. The measurement was carried out with a sample dimension of 2 mm × 15 mm × 15 mm, at a measurement temperature of 23°C, and a compression rate of 1 mm/min.

<Rate of change of 30% compressive strength after heat resistance test>

The obtained heat-conductive resin sheet was heated for 1000 hours at 150°C in an oven and measured for a 30% compressive strength to determine rates of changes of physical properties after the heat resistance test by the following formula. The rate of change of the 30% compressive strength after the heat resistance test was determined by the following formula (1).

$$|(1 - 30\% \text{ Compressive strength before heat resistance test} / 30\% \text{ compressive strength after heat resistance test}) \times 100| \quad \text{Formula (1)}$$

<Attachment test>

Attachment test was carried out by which each of the obtained heat-conductive resin sheets before and after the heat resistance test was attached on a test substrate, on which a BGA (Ball Grid Array) was mounted, in such a way as to be 30% compressed, and the presence or absence of faults such as solder cracks, short circuits, and discoloration after attachment was observed using an X-ray apparatus. Evaluations were made by the following evaluation criteria.

A: No fault
B: Cracks are observed.
C: Discoloration is observed.
D: Cracks and discoloration are observed.

<Gloss retention in fogging test>

In accordance with German industrial standard DIN75201-A, the gloss retention was measured and the clouding degree of glass was evaluated as described below.
A disk-shaped heat-conductive resin sheet having a thickness of 2 mm and a diameter of 80 mm was placed in a beaker having a height of 1000 mL, a glass plate was put on the top of the beaker so as to cover the beaker, and a cooling plate maintained at a temperature of 21°C was further put on the glass plate. Subsequently, the beaker including the heat-conductive resin sheet was heated to 100°C in an oil bath. Then, after the beaker was maintained in this state for 16 hours, the glossiness of the surface of the glass plate was measured. From the gloss value of the glass plate after the test thus obtained (gloss value after test) and the gloss value of the glass plate before the test (gloss value before test), the gloss retention was determined by the following formula, and the clouding degree of glass was evaluated by the following criteria.

$$\text{Gloss retention } (\%) = 100 \times (\text{gloss value after test}) / (\text{gloss value before test})$$

The above gloss value is the gloss value at 60°, which is a value measured with a gloss meter (manufactured by Murakami Color Research Laboratory, "Precision Gloss Meter GM-26PRO").

A: Gloss retention is 80% or more.
B: Gloss retention is 60% or more and less than 80%.
C: Gloss retention is 40% or more and less than 60%.
D: Gloss retention is less than 40%.

(Example 1)

A mixture consisting of 100 parts by mass of a liquid elastomer 1 (manufactured by KURARAY CO., LTD., product name "L-1203") and 330 parts by mass of boron nitride (manufactured by Denka Company Limited., product

**EP 4 040 479 A1**

name "SGP") was melt-kneaded and then pressed to obtain a sheet-like resin layer having a thickness of 0.5 mm, a width of 80 mm and a depth of 80 mm. For the subsequent lamination step, the obtained resin layer was cut into 16 even pieces and superimposed to obtain a laminated body consisting of 16 layers and having a total thickness of 8 mm, a width of 20 mm and a depth of 20 mm. Then, the laminated body was sliced parallel to the lamination direction thereby to obtain a heat-conductive resin sheet having a thickness of 2 mm, a width of 8 mm and a length of 20 mm. A single layer of the resin layers composing the laminated body of the heat-conductive resin sheet had a thickness of 0.5 mm. Then, both surfaces of the heat-conductive resin sheet were irradiated with an electron beam having an accelerating voltage of 525 kV and a dose of 600 kGy thereby to crosslink the sheet. This heat-conductive resin sheet was evaluated for each of the items shown in Table 1.

(Examples 2 and 3 and Comparative Examples 1 and 2)

A heat-conductive resin sheet was obtained in the same manner as in Example 1, except that the composition was changed as shown in Table 1. This heat-conductive resin sheet was evaluated for each of the items shown in Table 1.

Table 1

|  |  |  | Example | | | Comparative Example | |
|---|---|---|---|---|---|---|---|
|  |  |  | 1 | 2 | 3 | 1 | 2 |
| Composition | Resin [part by mass] | Liquid elastomer 1 (L-1203) | 100 | 100 | 100 | 100 | 100 |
|  | Heat-conductive filler [part by mass] | Boron nitride | 330 | 330 | 330 | 330 | 330 |
|  | Antioxidant [part by mass] | Antioxidant 1 AO-60 |  |  |  |  | 1.2 |
|  |  | Antioxidant 2 CDA-1 |  | 2 |  | 2 | 1.2 |
|  |  | Antioxidant 3 NOCRAC 400S |  |  |  | 1 | 0.6 |
|  |  | Antioxidant 4 AO-330 |  |  | 2 |  |  |
|  |  | Antioxidant 5 NOCRAC white | 2 | 0.5 |  |  |  |
| Presence or absence of ester bond of antioxidant used | | | No | No | No | Yes | Yes |
| Presence or absence of tertiary/quaternary carbon in antioxidant used | | | No | No | Yes | No | Yes |
| Content of compound having ester bond (ppm) | | | 0 | 0 | 0 | 2310 | 4160 |
| Electron beam crosslinking conditions | | | 525 kV 600 kGy | 525 kV 600 kGy | 525 kV 600 kGy | 525 kV 600 kGy | 525 kV 600 kGy |
| Evaluation | Thermal conductivity [W/m·K] | | 10.9 | 12.4 | 10.8 | 10.1 | 10.5 |
|  | 30% Compressive strength [kPa] | | 973 | 749 | 650 | 666 | 650 |
|  | 30% Compressive strength after heat resistance test [kPa] | | 848 | 762 | 571 | 830 | 749 |
|  | Rate of change of 30% compressive strength [%] | | 15 | 2 | 14 | 20 | 13 |
|  | Attachment test (before heat resistance test/after heat resistance test) | | A/A | A/A | A/B | A/A | A/B |
|  | Gloss retention (%) | | 80 | 84 | 73 | 51 | 41 |
|  | clouding degree of glass | | A | A | B | C | C |

The heat-conductive resin sheets of the present invention shown in Examples 1 to 3 had high thermal conductivity, flexibility and satisfactory results on the attachment test with long-term stability of physical properties without becoming hardened over time. Additionally, it was revealed that clouding of glass is easily prevented. To the contrary, it was revealed that the heat-conductive resin sheets shown in Comparative Example 1 and 2 include a large amount of the compound having an ester group and it is difficult for the resin sheets to prevent clouding of glass.

Reference Signs List

1    Heat-conductive resin sheet
2    Resin layer
3    Heating element
4    Heat sink
5    Sheet surface
6    Heat-conductive filler
7    Heat-conductive resin layer
8    Resin

**Claims**

1. A heat-conductive resin sheet having a thermal conductivity of 5 W/m·K or more, a 30% compressive strength of 2000 kPa or less, a content of a compound having an ester bond of 1000 ppm or less, and a rate of change of the 30% compressive strength of 30% or less after a heat resistance test.

2. A heat-conductive resin sheet having a thermal conductivity of 5 W/m·K or more, a 30% compressive strength of 2000 kPa or less, a gloss retention in a fogging test of 70% or more, and a rate of change of the 30% compressive strength of 30% or less after a heat resistance test.

3. The heat-conductive resin sheet according to claim 1, wherein the gloss retention in a fogging test is 70% or more.

4. The heat-conductive resin sheet according to any of claims 1 to 3, comprising an antioxidant.

5. The heat-conductive resin sheet according to claim 4, wherein the antioxidant is an antioxidant having no ester bond.

6. The heat-conductive resin sheet according to claim 5, wherein the antioxidant is an antioxidant having no tertiary carbon nor quaternary carbon.

7. The heat-conductive resin sheet according to any of claims 1 to 6, comprising an elastomer resin.

8. The heat-conductive resin sheet according to claim 7, wherein the elastomer resin comprises a liquid elastomer resin.

9. The heat-conductive resin sheet according to any of claims 1 to 8, comprising a heat-conductive filler.

10. The heat-conductive resin sheet according to claim 9, wherein the heat-conductive filler comprises a non-spherical filler.

11. The heat-conductive resin sheet according to any of claims 1 to 10, which is crosslinked.

# Fig 1

FILLER THICKNESS

7(2)

6    8

5

1

SHEET
THICKNESS

RESIN LAYER WIDTH    5

SHEET WIDTH

Fig 2

<table>
<tr><td colspan="2" align="center">**INTERNATIONAL SEARCH REPORT**</td><td>International application No.<br>PCT/JP2020/036869</td></tr>
</table>

| A. CLASSIFICATION OF SUBJECT MATTER |
|---|
| H01L 23/36(2006.01)i; H01L 23/373(2006.01)i; C08L 5/00(2006.01)i; C08L 21/00(2006.01)i; C08J 5/18(2006.01)i; C08K 3/01(2018.01)i <br> FI: H01L23/36 M; C08K3/01; C08L5/00; C08L21/00; H01L23/36 D; C08J5/18 CEQ <br> According to International Patent Classification (IPC) or to both national classification and IPC |

| B. FIELDS SEARCHED |
|---|
| Minimum documentation searched (classification system followed by classification symbols) <br> C08J5/18; H01L23/36; H01L23/373; C08L5/00-5/59; C08L1/00-101/14; C08K3/00-3/40 |

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X <br> A | JP 2014-145024 A (TAICA CORPORATION) 14 August 2014 (2014-08-14) claims, paragraphs [0003]–[0004], [0020]–[0021], examples | 1-7, 9-11 <br> 8 |
| X <br> A | JP 2016-030774 A (SHIN-ETSU CHEMICAL CO., LTD.) 07 March 2016 (2016-03-07) claims, paragraphs [0032], [0038]–[0040], examples | 1-7, 9-11 <br> 8 |
| A | JP 2013-100444 A (SUMITOMO CHEMICAL CO., LTD.) 23 May 2013 (2013-05-23) claims, paragraphs [0027]–[0048], examples | 1-11 |
| A | CN 109852044 A (ANHUI JIHONG MATERIAL TECHNOLOGY CO., LTD.) 07 June 2019 (2019-06-07) claims, examples | 1-11 |

☒ Further documents are listed in the continuation of Box C.  ☒ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search <br> 07 December 2020 (07.12.2020) | Date of mailing of the international search report <br> 15 December 2020 (15.12.2020) |
|---|---|
| Name and mailing address of the ISA/ <br> Japan Patent Office <br> 3-4-3, Kasumigaseki, Chiyoda-ku, <br> Tokyo 100-8915, Japan | Authorized officer <br><br> Telephone No. |

Form PCT/ISA/210 (second sheet) (January 2015)

| International application No. |
| --- |
| PCT/JP2020/036869 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | CN 105315414 A (SUZHOU TIANMAI THERMAL TECHNOLOGY CO., LTD.) 10 February 2016 (2016-02-10) claims, examples | 1-11 |
| A | JP 2006-160830 A (3M INNOVATIVE PROPERTIES COMPANY) 22 June 2006 (2006-06-22) claims, examples | 1-11 |
| A | JP 2012-233099 A (3M INNOVATIVE PROPERTIES COMPANY) 29 November 2012 (2012-11-29) claims, examples | 1-11 |
| A | JP 2015-111619 A (DIC CORPORATION) 18 June 2015 (2015-06-18) claims, examples | 1-11 |
| A | WO 2019/159340 A1 (HITACHI CHEMICAL CO., LTD.) 22 August 2019 (2019-08-22) claims, examples | 1-11 |
| A | WO 2018/123012 A1 (HITACHI CHEMICAL CO., LTD.) 05 July 2018 (2018-07-05) claims, examples | 1-11 |
| A | WO 2016/068240 A1 (KITAGAWA INDUSTRIES CO., LTD.) 06 May 2016 (2016-05-06) claims, examples | 1-11 |
| A | WO 2019/022070 A1 (SEKISUI CHEMICAL CO., LTD.) 31 January 2019 (2019-01-31) claims, paragraph [0020], examples | 1-11 |
| A | WO 2018/101445 A1 (SEKISUI CHEMICAL CO., LTD.) 07 June 2018 (2018-06-07) claims, paragraph [0020], examples | 1-11 |

Form PCT/ISA/210 (continuation of second sheet) (January 2015)

**INTERNATIONAL SEARCH REPORT**
Information on patent family members

| International application No. |
|---|
| PCT/JP2020/036869 |

| Patent Documents referred in the Report | Publication Date | Patent Family | Publication Date |
|---|---|---|---|
| JP 2014-145024 A | 14 Aug. 2014 | (Family: none) | |
| JP 2016-030774 A | 07 Mar. 2016 | US 2017/0210964 A1 claims, paragraphs [0059], [0065]-[0069], examples WO 2016/017495 A1 EP 3176220 A1 CN 106574120 A KR 10-2017-0037993 A | |
| JP 2013-100444 A | 23 May 2013 | US 2012/0238674 A1 claims, paragraphs [0051]-[0072], examples DE 102012005146 A CN 102675805 A | |
| CN 109852044 A | 07 Jun. 2019 | (Family: none) | |
| CN 105315414 A | 10 Feb. 2016 | (Family: none) | |
| JP 2006-160830 A | 22 Jun. 2006 | US 2008/0081859 A1 claims, examples WO 2006/062614 A1 EP 1833903 A1 | |
| JP 2012-233099 A | 29 Nov. 2012 | US 2014/0166258 A1 claims, examples WO 2012/151101 A2 TW 201302375 A CN 103502329 A KR 10-2014-0025491 A | |
| JP 2015-111619 A | 18 Jun. 2015 | (Family: none) | |
| WO 2019/159340 A1 | 22 Aug. 2019 | (Family: none) | |
| WO 2018/123012 A1 | 05 Jul. 2018 | TW 201830615 A CN 110114871 A KR 10-2019-0100208 A | |
| WO 2016/068240 A1 | 06 May 2016 | US 2017/0321049 A1 claims, examples EP 3214150 A1 | |
| WO 2019/022070 A1 | 31 Jan. 2019 | CN 110945647 A TW 201908460 A | |
| WO 2018/101445 A1 | 07 Jun. 2018 | US 2019/0241786 A1 claims, examples EP 3549974 A1 CN 109843991 A KR 10-2019-0087431 A | |

Form PCT/ISA/210 (patent family annex) (January 2015)

**EP 4 040 479 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012038763 A
- JP 2013254880 A